# EUROPEAN PATENT APPLICATION

(11) **EP 2 579 382 A2**
(43) Date of publication of application: **10.04.2013**
(21) Application number: 11789997.1
(22) Date of filing: 30.05.2011
(51) Int. Cl.: H01M 10/44, H02J 7/00, H01M 10/48, H01M 10/50, G01R 31/36

(54) **BATTERY PACK AND METHOD FOR CHARGING BATTERY PACK**

(30) Priority: 23.05.2011 KR 20110048711; 03.06.2010 KR 20100052510
(71) Applicant: Jung, Eun-Ey, Gyeonggi-do 413-758 (KR)
(72) Inventor: Jung, Eun-Ey, Gyeonggi-do 413-758 (KR)
(74) Representative: Modiano, Micaela Nadia
(86) International application number: PCT/KR2011/003953
(87) International publication number: WO 2011/152639

(57) **Abstract**

Disclosed is a battery pack including: a plurality of cell modules including a plurality of battery cells; and a battery management system for transmitting a control signal on charging to at least one of the plurality of cell modules based on state information of a battery cell transmitted by the cell modules, and controlling a current supplied to the cell modules by an external charger based on the state information, wherein the cell modules are charged to a predetermined capacity of the battery cell in connection with the external charger, and are charged to full capacity of the battery cell individually according to the control signal so the battery pack is fully charged very quickly without a cell balancing process.

## Description

### BACKGROUND

### (a) Field

The present invention relates to a battery pack and a method for charging a battery pack.

### (b) Description of the Related Art

Electronic devices such as laptops or mobile phones and vehicles receive energy from batteries. Such batteries can be manufactured as a battery pack including battery cells and various circuits. Regarding the battery pack, the battery cells are charged by an external charger and the battery pack is repeatedly discharged to supply voltage and current to external loads such as electronic devices or vehicles.

In the conventional battery packs, the battery cells are coupled in series and are charged by using an external charger. In this instance, the cells may fail to be uniformly charged or discharged and charging deviation or discharging deviation may occur. The battery pack performs a cell balancing process so as to correct the deviation, which takes much time and increases the time for charging the battery pack.

The above information disclosed in this Background section is only for enhancement of understanding of the background of the invention and therefore it may contain information that does not form the prior art that is already known in this country to a person of ordinary skill in the art.

### SUMMARY

The present invention has been made in an effort to provide a battery pack for monitoring and controlling cell modules by using a battery management system, quickly charging the battery pack with predetermined energy by using an external charger, and charging each battery cell by using a cell charger of the cell module to thereby fully charge them quickly without deviation between the cells, and a method for charging a battery pack.

An exemplary embodiment of the present invention provides a battery pack including: a plurality of cell modules including a plurality of battery cells; and a battery management system for transmitting a control signal on charging to at least one of the plurality of cell modules based on state information of a battery cell transmitted by the cell modules, and controlling a current supplied to the cell modules by an external charger based on the state information, wherein the cell modules are charged to a predetermined capacity of the battery cell in connection with the external charger, and are charged to full capacity of the battery cell according to the control signal.

The cell module further includes a controller for monitoring a state of the battery cell, transmitting monitored state information to the battery management system, and receiving the control signal, and a cell charger for charging the battery cell by control of the controller.

The controller monitors voltage, current, and temperature of the battery cell.

The battery pack further includes a switch located between one end of the battery cells coupled in series according to polarity and one end of the external charger, wherein the battery management system controls turn-on/off of the switch.

When one of the plurality of cell modules reaches a reference voltage, the battery management system controls the switch based on the state information to stop a current supplied to the battery cells by the external charger.

When the current supplied to the battery cells by the external charger is stopped, the battery management system analyzes states of the cell modules based on the state information, and transmits a control signal to the cell modules so as to be individually charged to full capacity from the external charger.

The battery management system sets a normal operational range of the cell modules based on at least one of the voltage, the current, and the temperature, and when at least one of the cell modules fails to satisfy the normal operational range based on the state information, the battery management system controls the switch to stop the current supplied to the battery cells by the external charger.

The battery management system manages the state information provided by the cell modules, and checks performance of the cell modules to determine a replacement.

The state information includes temperature information, and the battery management system compares temperatures of the cell modules with a reference temperature based on the state information, and transmits a control signal for operating a heating mat to the cell module having a temperature that is less than the reference temperature, and operates a cooling device when there is a cell module with a temperature that is greater than the reference temperature.

Another embodiment of the present invention provides a method for a battery management system of a battery pack to charge a plurality of cell modules including a plurality of battery cells, including: charging the battery cells by using current supplied by an external charger; monitoring states of the cell modules and determining whether one of the cell modules reaches a reference voltage; stopping the charging process when there is a cell module reaching the reference voltage; and analyzing state information of the cell modules and transmitting control signals to the cell modules so that the cell modules may be individually charged to full capacity of the battery cell.

The determining is performed based on voltage information of the battery cells provided by the cell modules.

The stopping includes reducing a current supply by controlling the external charger, and stopping the current supplied to the battery cells by the external charger by controlling a switch between the external charger and the cell modules.

According to the embodiments of the present invention, the battery pack is manufactured by connecting cell modules including a battery cell and a cell charger so each cell module can be replaced, and it is easy to replace a bad cell of the battery pack. Further, the battery management system and the cell module monitor states of the cell modules and transmit and receive information with each other, and the cell module charges the individual battery cells by using the cell charger included in the cell module rather than by using the external charger. Therefore, there is no need to perform cell balancing for reducing inter-cell deviation occurring when externally charging or discharging, and the battery pack is fully charged within a short time.

### BRIEF DESCRIPTION OF THE DRAWINGS

FIG. 1 shows a block diagram of a battery pack according to an exemplary embodiment of the present invention.
FIG. 2 shows a block diagram of a cell module according to an exemplary embodiment of the present invention.
FIG. 3 and FIG. 4 show a configuration diagram of a cell module according to an exemplary embodiment of the present invention.
FIG. 5 shows a perspective view of a battery pack according to an exemplary embodiment of the present invention.
FIG. 6 shows a schematic diagram of a power and control signal of a battery pack according to an exemplary embodiment of the present invention.
FIG. 7 shows a schematic diagram of a power and control signal of a battery pack according to another exemplary embodiment of the present invention.
FIG. 8 and FIG. 9 show a connection state of a battery pack according to an exemplary embodiment of the present invention.
FIG. 10 shows a flowchart of a method for charging a battery pack according to an exemplary embodiment of the present invention.

### DETAILED DESCRIPTION

In the following detailed description, only certain exemplary embodiments have been shown and described, simply by way of illustration. As those skilled in the art would realize, the described embodiments may be modified in various different ways, all without departing from the spirit or scope of the inventive concept. Accordingly, the drawings and description are to be regarded as illustrative in nature and not restrictive. Like reference numerals designate like elements throughout the specification.

Throughout the specification, unless explicitly described to the contrary, the word "comprise" and variations such as "comprises" or "comprising" will be understood to imply the inclusion of stated elements but not the exclusion of any other elements.

A battery pack and a method for charging a battery pack according to exemplary embodiments will now be described with reference to accompanying drawings.

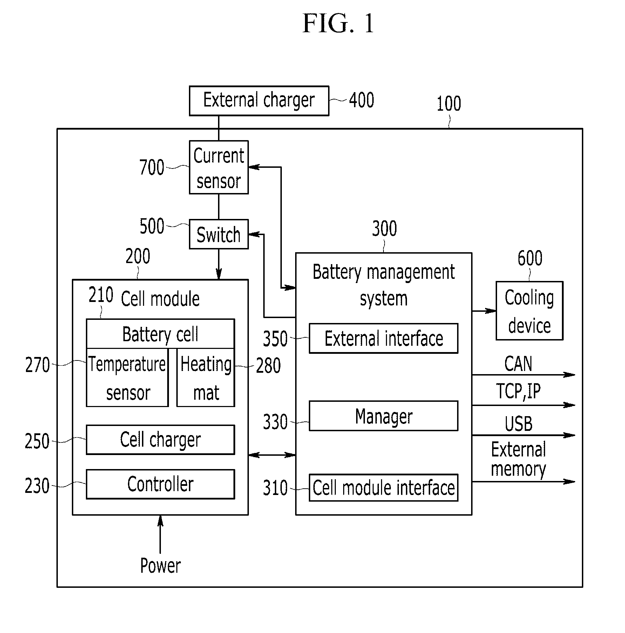

FIG. 1 shows a block diagram of a battery pack according to an exemplary embodiment of the present invention.

Referring to FIG. 1, the battery pack 100 includes a plurality of cell modules 200 and a battery management system (BMS) 300. The battery pack 100 connects the cell modules 200 in series, parallel, or a combination of series and parallel, and the respective cell modules are connected to the battery management system 300. The battery pack 100 receives current from an external charger 400 to charge the battery cells, and it supplies the current to an external load (not shown) and is then discharged. The battery pack 100 further includes a switch 500 between the external charger 400 and the cell module 200, a cooling device 600 for cooling the battery pack 100, and a current sensor 700 for sensing the current flowing to the battery pack 100.

The cell module 200 includes a battery cell 210, a controller 230, a cell charger 250, a temperature sensor 270, and a heating mat 280. The cell module 200 communicates with the battery management system 300 to transmit signals thereto and receive them therefrom. The cell module 200 receives power to drive the controller 230 and the cell charger 250, and in this instance, it can receive power from the external charger 400.

The battery cell 210 is rechargeable. The battery cell 210 can be charged by current supplied from the external charger 400, and it can be individually charged by current appropriate for the state of the battery cell 210, supplied from the cell charger 250. The battery cell 210 can be charged in various ways, and for example, it can be charged by the constant current/constant voltage (CC/CV) method or a method designated by the battery management system 300.

The controller 230 monitors the state of the battery cell 210 and periodically transmits the state information to the battery management system 300. In this instance, the controller 230 monitors voltage, current, and temperature of the battery cell 210. The controller 230 controls the cell charger 250 based on control signals transmitted by the battery management system 300. When receiving the control signal for charging the battery cell 210 from the battery management system 300, the controller 230 controls the cell charger 250 to charge the rest of the battery cell 210. In this instance, the controller 230 controls the cell charger 250 to fully charge the battery cell 210 depending on the state of the battery cell 210.

The cell charger 250 charges the battery cell 210 by control of the controller 230. The cell charger 250 fully charges the battery cell 210 according to the state of the battery cell 210. In this instance, the cell charger 250 uses power supplied from the external charger 400 to charge the battery cell 210.

The temperature sensor 270 and the heating mat 280 are used to operate the temperature of the battery cell 210 within a predetermined reference range. The temperature sensor 270 measures the temperature of the battery cell 210 and transmits it to the controller 230. The heating mat 280 is operated by the controller 230 and increases the temperature of the battery cell 210. In this instance, the temperature sensor 270 may be a negative temperature coefficient (NTC) temperature sensor, a device having electrical resistance related to temperature.

The battery management system 300 includes a cell module interface 310 communicating with the cell module 200, a manager 330, and an external interface 350.

The cell module interface 310 communicates with the cell module 200 to receive state information of the battery cell 210 from the cell module 200, and transmits various control signals to the cell module 200.

The manager 330 manages the cell module 200 and various connection devices, based on the information provided by the cell module interface 310.

The manager 330 controls the switch 500 to control the current supplied by the external charger 400. For example, when one of a plurality of cell modules reaches a reference voltage which is a charging stop voltage, the manager 330 stops the current supply to a plurality of battery cells from the external charger 400. The manager 330 determines charging method of the cell module based on the state information of the cell module, the voltage and the current. And the manager 330 transmits a control signal for charging the rest individually, to the cell module.

The manager 330 monitors the cell module 200 based on the information of the battery cell 210 transmitted from the cell module 200. The manager 330 transmits a control signal on charging to at least one of a plurality of cell modules. In this instance, when the temperature of the battery cell 210 is greater than a reference temperature, the manager 330 may operate the cooling device 600 to cool the battery pack 100. When the temperature of the battery cell 210 is less than the reference temperature, the manager 330 may transmit a control signal for operating the heating mat 280 to the corresponding cell module.

The manager 330 knows that the battery pack 100 is overdischarged, overcharged, or out of an appropriate temperature through the current sensor 700. That is, the manager 330 controls the switch 500 to protect the battery pack 100 when the current flowing to the battery pack 100 from the external charger 400 or the current flowing to an external load (not shown) from the battery pack 100 digresses from the safety range.

Also, the manager 330 uses an identity number of the assembled cell modules to manage history of the respective cell modules. The manager 330 performs an aging process during the process for manufacturing the battery pack 100, evaluates the battery cell based on charging and discharging capacity of the battery cell, and determines bad battery cells that are below a predetermined standard. The manager 330 calculates a residual lifespan of the battery cell based on a change of available capacity of the battery cell in use, internal resistance, and a number of charges and discharges, and then displays a replacement indicator of a cell module of the lifespan-expired battery cell.

The external interface 350 can communicate with an external device of the battery pack 100. For example, the external interface 350 can include a TCP/IP port, a USB port, a controller area network (CAN) communication port, and an external memory connector.

The switch 500 is opened or closed based on control of the battery management system 300. The switch 500 is a power controllable element, and it can be an insulated gate bipolar transistor (IGBT) or a power field effect transistor (FET). The switch 500 can be realized as a magnetic contactor (MC) type.

The current sensor 700 can be a Hall sensor or a shunt resistor.

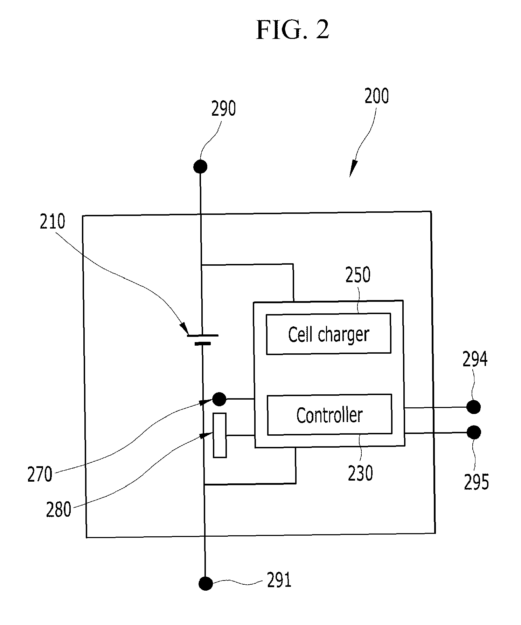

FIG. 2 shows a block diagram of a cell module according to an exemplary embodiment of the present invention.

Referring to FIG. 2, the cell module 200 includes a battery cell 210, a controller 230, a cell charger 250, a temperature sensor 270, and a heating mat 280. The cell module 200 is connected to another battery cell or an external charger through a positive electrode connection terminal 290 and a negative electrode connection terminal 291. The cell module 200 further includes a communication connection terminal 294 for communicating with the battery management system 300, and a power connection terminal 295 to which power of the cell module 200 is connected. The battery cell 210 can be charged by receiving the current from the external charger 400 through the positive electrode connection terminal 290 and the negative electrode connection terminal 291, and it can also be charged individually by receiving a current that is appropriate for the state of the battery cell 210 from the cell charger 250.

The controller 230 measures the voltage and the current charged of the battery cell 210, and monitors the temperature through the temperature sensor 270. The controller 230 periodically transmits the monitored state information to the battery management system 300. In this instance, the controller 230 operates the heating mat 280 to increase the temperature of the battery cell 210 when the temperature of the battery cell 210 is less than the reference temperature. The controller 230 controls the cell charger 250 based on the control signal received from the battery management system 300. When receiving the control signal for charging the battery cell 210 from the battery management system 300, the controller 230 controls the cell charger 250 to charge the battery cell 210 to full capacity.

The cell charger 250 charges the battery cell 210 according to control by the controller 230. The cell charger 250 fully charges the battery cell 210 according to the state of the battery cell 210. In this instance, the cell charger 250 charges the battery cell 210 by cell charging power. The cell charger 250 receives the cell charging power through the power connection terminal 295, and the cell charging power can be AC power or DC power.

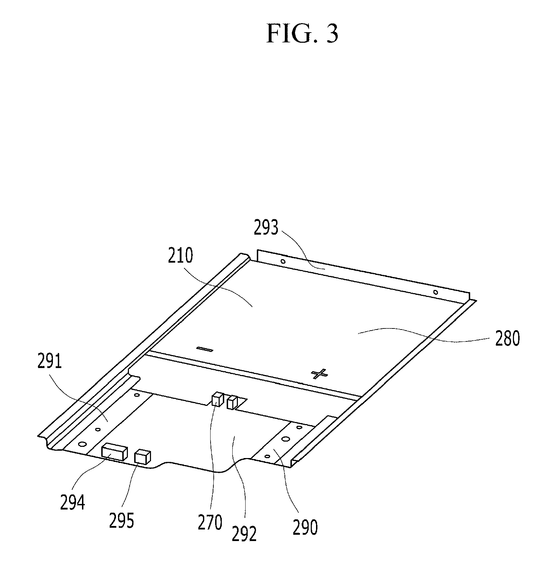

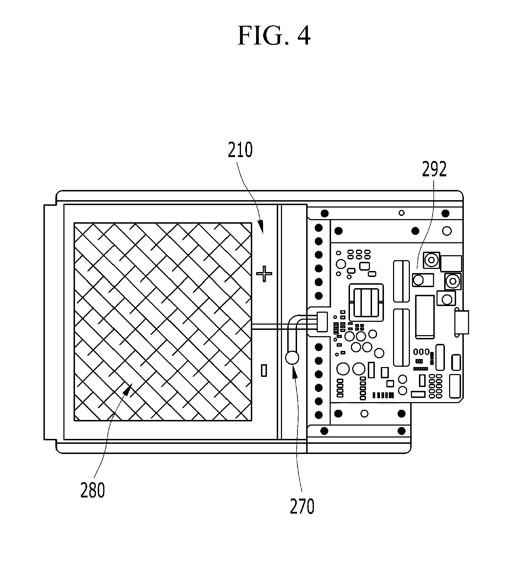

FIG. 3 and FIG. 4 show a configuration diagram of a cell module according to an exemplary embodiment of the present invention.

Referring to FIG. 3, the cell module 200 includes a control board 292 on which the controller 230 and the cell charger 250 are realized, a battery cell 210, a temperature sensor 270, and a heating mat 280 provided above or below the battery cell 210, mounted in a cell tray 293. The cell tray 293 further includes a positive electrode connection terminal 290, a negative electrode connection terminal 291, a communication connection terminal 294, and a power connection terminal 295.

Referring to FIG. 4, the cell module 200 includes a control board 292 on which the controller 230 and the cell charger 250 are realized, a battery cell 210, a temperature sensor 270, and a heating mat 280 provided above or below the battery cell 210, mounted in a cell tray 293.

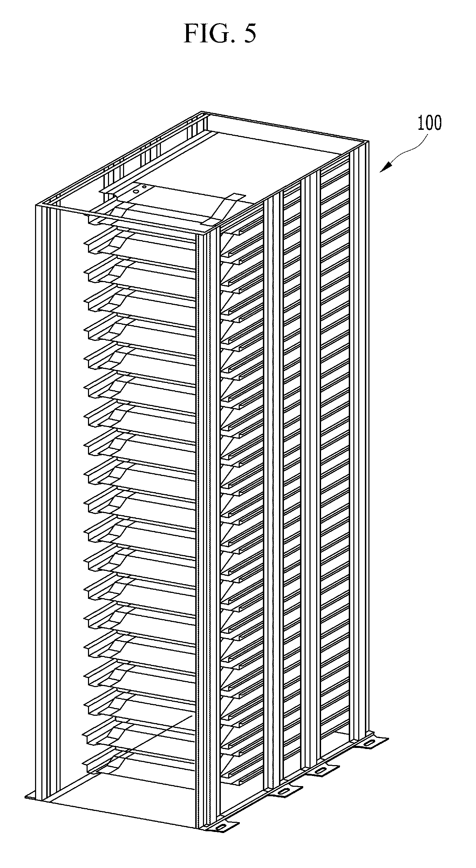

FIG. 5 shows a perspective view of a battery pack according to an exemplary embodiment of the present invention.

Referring to FIG. 5, the battery pack 100 includes a plurality of cell modules 200 which can be connected in one of series, parallel, and a combination of series and parallel, and the stacked cell modules are respectively connected to the battery management system 300. The cell modules 200 can be stacked in various ways, and for example, as shown in FIG. 5, they can be stacked by putting one cell module in one layer, or by stacking at least two cell modules in one layer.

When the prior art battery pack is manufactured, the battery cells are assembled into a pack to which various circuits are connected, so it is difficult to replace a bad battery cell. However, regarding the battery pack 100 using cell modules 200, it is easy to replace a bad cell. So user can use the battery pack 100 for a long time by replaing bad cells. Also, since the cell modules 200 are individually fully charged, the battery pack 100 does not need to undergo a cell balancing process for reducing the voltage of the battery pack by performing a balancing process with a battery cell with a low voltage. Therefore, the battery pack 100 is charged with the external charger 400, and it is fully charged up to the maximum charging voltage of the battery pack 100 without lowering the voltage, thereby increasing available capacity of the battery pack.

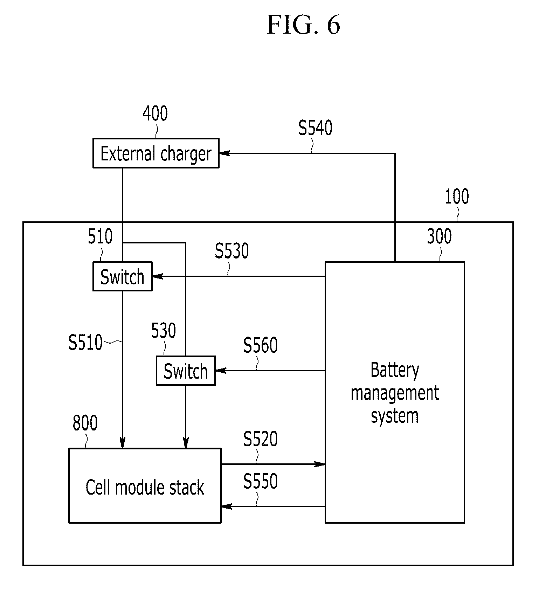

FIG. 6 shows a schematic diagram of a power and control signal of a battery pack according to an exemplary embodiment of the present invention.

Referring to FIG. 6, the battery pack 100 charges and discharges the battery cells through a cell module stack 800 formed by stacking cell modules 200, and the battery management system 300. The battery management system 300 controls a current flow between the cell module stack 800 and the external charger 400 through switches 510 and 530. In this instance, the switch 530 can be omitted depending on the circuit.

When the external charger 400 is connected to the battery pack 100, a current is supplied to the cell module stack 800 from the external charger 400 (S510).

The respective cell modules of the cell module stack 800 transmit voltage, current, and temperature information of the battery cells to the battery management system 300 (S520).

When one of a plurality of cell modules reaches a reference voltage, the battery management system 300 transmits a control signal to the switch 510 so as to stop the current supplied to the battery cells from the external charger 400 (S530).

In another way, the battery management system 300 can transmit a control signal to the external charger 400 before turning off the switch 510 so that the external charger 400 may reduce the supplied current (S540).

The battery management system 300 transmits a control signal to the cell module stack 800 so as to individually charge the battery cells to full capacity based on the states of the cell modules (S550). The battery management system 300 can transmit the control signal so as to charge them according to the CC/CV method.

In this instance, the battery management system 300 turns on the switch 530 to supply power to the cell modules from the external charger 400 (S560). The cell modules can be connected in series, in parallel, or in a combination of series and parallel to receive power through the switch 530.

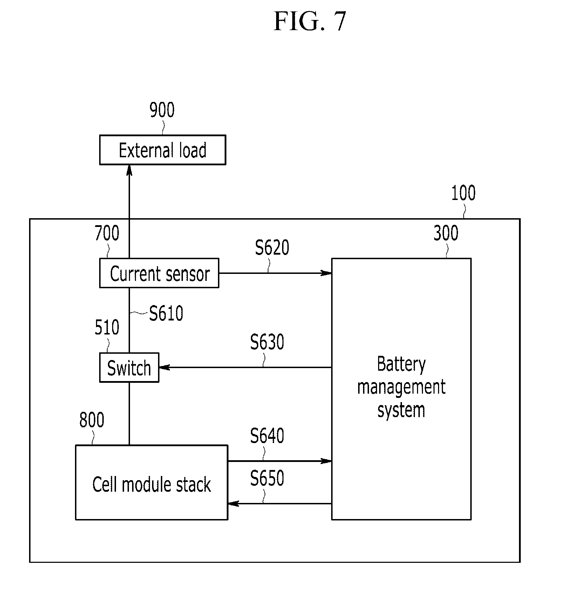

FIG. 7 shows a schematic diagram of a power and control signal of a battery pack according to another exemplary embodiment of the present invention.

Referring to FIG. 7, when an external load 900 is connected to the battery pack 100, the current flows to the external load 900 from the cell module stack 800 (S61 0).

The battery management system 300 monitors the current flowing to the external load 900 from the cell module stack 800 through the current sensor 700 (S620).

When the current sensed by the current sensor 700 digresses from the safety range, the battery management system 300 transmits a control signal to the switch 510 to control the current (S630).

The respective cell modules of the cell module stack 800 transmit the voltage, current, temperature information of the battery cells to the battery management system 300 (S640).

The battery management system 300 analyzes the states of the cell modules based on the information transmitted by the cell module stack 800, and transmits a control signal to the cell module stack 800 (S650).

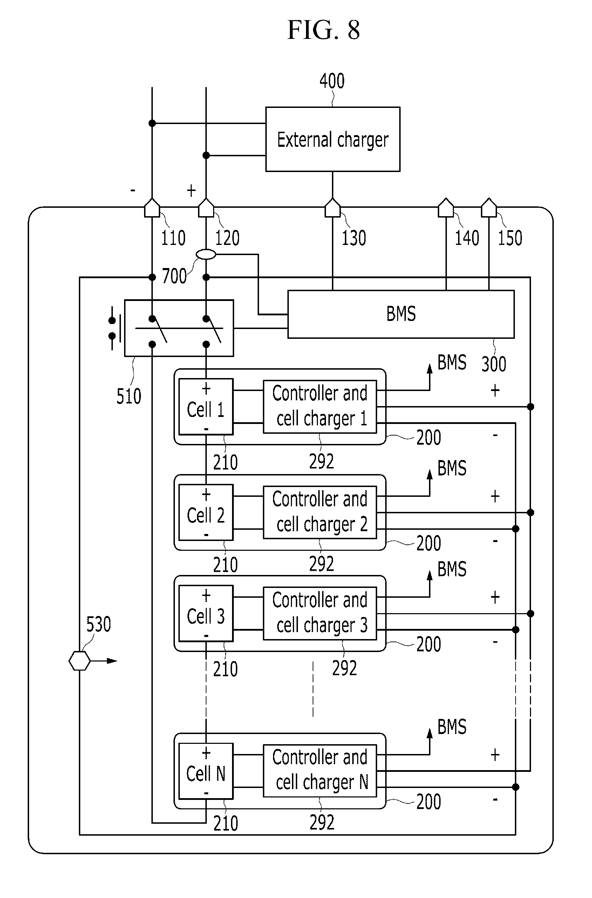

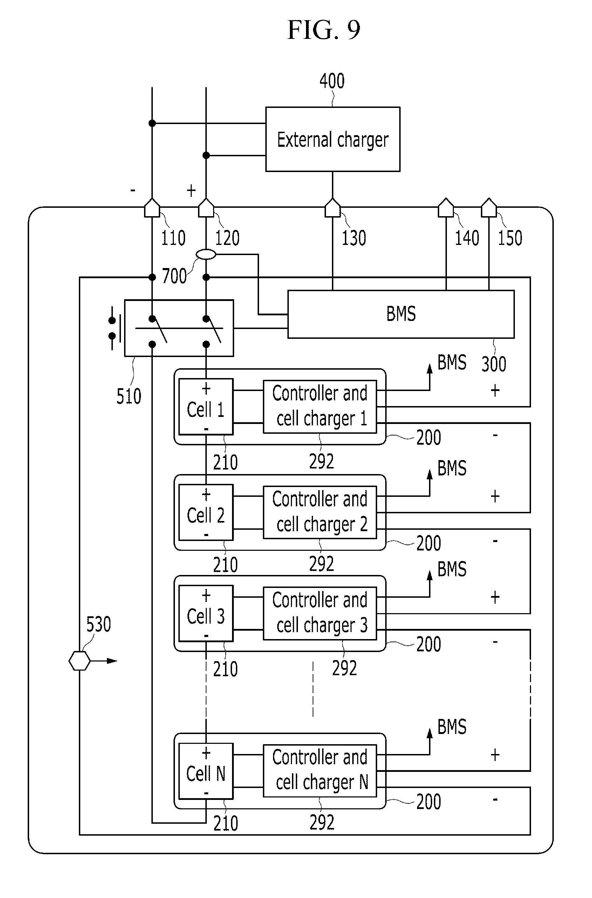

FIG. 8 and FIG. 9 show a connection state of a battery pack according to an exemplary embodiment of the present invention.

Referring to FIG. 8, the battery pack 100 includes a plurality of terminals 110, 120, 130, 140, and 150 connected to an external device.

The terminals 110 and 120 are input and output terminals of the battery pack 100, and are connected to the external charger 400 or an external load (not shown).

The terminal 130 communicates with the external charger 400.

The battery management system 300 can receive power from the outside through the terminal 140 or from cell module stack 800. Depending on the design, the battery management system 300 can receive power from an inner part of the battery pack 100.

The battery management system 300 communicates with the external device and transmits and receives control signals thereto and therefrom through the terminal 150. The battery management system 300 communicates with various sorts of devices such as an external inverter through the terminal 150 to transmit and receive signals. Also, the battery management system 300 transmits an operation state of the battery management system 300 and the states of the cell modules to the external device. For example, the battery management system 300 can transmit a state of charge (SOC) and a state of health (SOH), battery-related information, to the external device connected to the terminal 150.

The current sensor 700 is provided on at least one line to which the terminals 110 and 120 and the cell module are connected.

N (N is a natural number) cell modules 200 are connected, and the cell modules respectively include a battery cell 210 and a control board 292 on which the controller 230 and the cell charger 250 are realized. The N battery cells are coupled in series according to polarity, the negative electrode of the battery cells coupled in series are connected to the terminal 110 through the switch 510, and the positive electrode of the battery cells coupled in series are connected to the terminal 120 through the switch 510. Further, the cell modules are coupled in parallel to the terminals 110 and 120 to receive power. The switch 530 can be provided between the cell module and the terminals (110/120). The cell module is connected to the battery management system 300. The cell charger 250 receives power to charge the battery cell 210, cell charging power of the module is AC power or DC power, DC power is supplied to the cell module through the switch 530, and the cell charger can fully charge the battery cell through AC power (not shown).

The battery management system 300 is connected to and communicates with N cell modules 200, switches 510 and 530, a current sensor 700, and terminals 130,140, and 150.

Referring to FIG. 9, the battery pack 100 includes a plurality of terminals 110, 120, 130, 140, and 150 connected to an external device, a battery management system 300, and a current sensor 700.

The N (N is a natural number) cell modules 200 are connected, and the cell modules respectively include a battery cell 210, a controller 230, and a cell charger 250. The N battery cells are coupled in series according to polarity, the negative electrode of the battery cells coupled in series are connected to the terminal 110 through the switch 510, and the positive electrode of the battery cells coupled in series are connected to the terminal 120 through the switch 510. Also, the cell modules are coupled in series, one end of the cell modules coupled in series is connected to the terminal 110, and other end of the cell modules coupled in series is connected to the terminal 120 to receive power. The switch 530 can be provided between the cell module and the terminals (110/120). The cell module is connected to the battery management system 300.

The battery management system 300 is connected to and communicates with N cell modules 200, switches 510 and 530, a current sensor 700, and terminals 130,140, and 150.

In FIG. 8 and FIG. 9, parallel and series connections are described, and the plurality of cell modules can be connected in a combination of series and parallel depending on the design.

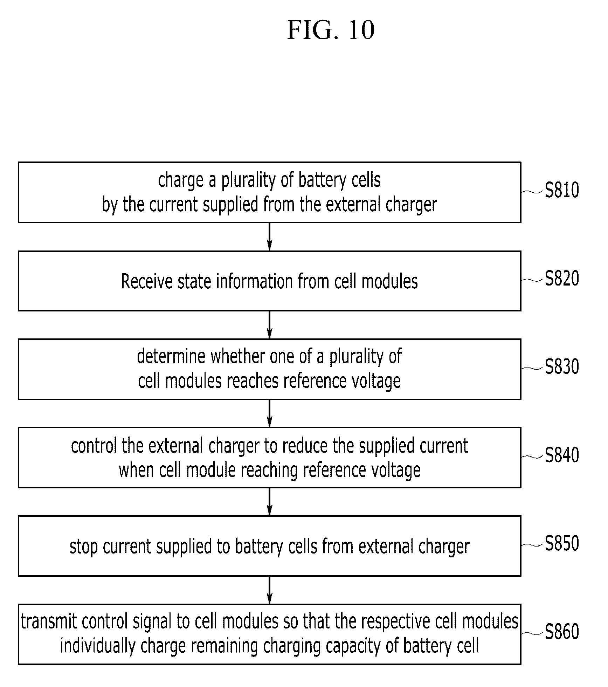

FIG. 10 shows a flowchart of a method for charging a battery pack according to an exemplary embodiment of the present invention.

Referring to FIG. 10, the battery management system 300 of the battery pack 100 charges a plurality of battery cells by the current supplied from the external charger 400 (S810). In this instance, the battery cells are charged simultaneously. The battery management system 300 turns on the switch 510 so that the current may be supplied to the battery cells from the external charger 400. The battery management system 300 can charge the battery cells through the CC/CV method.

The battery management system 300 receives state information from the cell modules (S820). The state information includes voltage, current, and temperature information of the battery cell.

The battery management system 300 determines whether one of a plurality of cell modules reaches a reference voltage (S830).

When there is a cell module reaching the reference voltage, the battery management system 300 controls the external charger 400 to reduce the supplied current (S840). The battery management system 300 can set a different amount of supplied current that is reduced depending on the maximum charging current of the cell module. Accordingly, the battery management system 300 prevents the voltage of the battery cell that is charged for the first time from being increased to be greater than the reference voltage, and thus protects the battery cell.

The battery management system 300 turns off the switch 510 between the external charger 400 and a plurality of cell modules to stop the current supplied to the battery cells from the external charger 400 (S850). In another way, when there is a cell module reaching the reference voltage, the battery management system 300 can control the external charger 400 to reduce the supplied current or turn off the switch 510 to block the current supplied to the battery cells from the external charger 400.

The battery management system 300 transmits a control signal to the cell modules so that the respective cell modules may individually charge the remaining capacity of the battery cell based on the state information transmitted by the cell modules (S860). The battery management system 300 analyzes voltage, current, and temperature information of the cell modules to determine a charging method that is appropriate for the cell module, and transmits a control signal to the corresponding cell module.

The cell charger 250 individually charges the battery cell according to the control signal provided by the battery management system 300. In this instance, the cell module monitors voltage, charging current, and temperature of the battery cell, and it is fully charged depending on the state of the battery cell. Therefore, the battery pack 100 does not need to undergo a cell balancing process for reducing the voltage of the battery pack by performing a balancing process with a low-voltage battery cell, and it is fully charged up to the maximum charging voltage of the battery pack 100 to thus increase the available capacity of the battery pack.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A battery pack comprising:
a plurality of cell modules including a plurality of battery cells; and
a battery management system for transmitting a control signal on charging to at least one of the plurality of cell modules based on state information of a battery cell transmitted by the cell modules, and controlling a current supplied to the cell modules by an external charger based on the state information, wherein
the cell modules are charged to a predetermined capacity of the battery cell in connection with the external charger, and are charged to full capacity of the battery cell individually according to the control signal.

2. The battery pack of claim 1, wherein
the cell module further comprises
a controller for monitoring a state of the battery cell, transmitting monitored state information to the battery management system, and receiving the control signal, and
a cell charger for charging the battery cell by control of the controller.

3. The battery pack of claim 2, wherein
the controller monitors voltage, current, and temperature of the battery cell.

4. The battery pack of claim 1, further comprising
a switch located between one end of the battery cells coupled in series according to polarity and one end of the external charger, wherein
the battery management system controls turn-on/off of the switch.

5. The battery pack of claim 4, wherein
when one of the plurality of cell modules reaches a reference voltage, the battery management system controls the switch based on the state information to stop a current supplied to the battery cells by the external charger.

6. The battery pack of claim 5, wherein
when the current supplied to the battery cells by the external charger is stopped, the battery management system analyzes states of the cell modules based on the state information and transmits a control signal to the cell modules so as to be individually charged to full capacity.

7. The battery pack of claim 4, wherein
the battery management system sets a normal operational range of the cell modules based on at least one of the voltage, the current, and the temperature, and when at least one of the cell modules fails to satisfy the normal operational range based on the state information, the battery management system controls the switch to stop the current supplied to the battery cells by the external charger.

8. The battery pack of claim 1, wherein
the battery management system manages the state information provided by the cell modules, and checks performance of the cell modules to determine a replacement.

9. The battery pack of claim 1, wherein
the state information includes temperature information, and
the battery management system compares temperatures of the cell modules with a reference temperature based on the state information, and transmits a control signal for operating a heating mat to the cell module having a temperature that is less than the reference temperature, and operates a cooling device when there is a cell module with a temperature that is greater than the reference temperature.

10. A method for a battery management system of a battery pack to charge a plurality of cell modules including a plurality of battery cell, comprising:
charging the battery cells by using current supplied by an external charger;
monitoring states of the cell modules and determining whether one of the cell modules reaches a reference voltage;
stopping the charging process when there is a cell module reaching the reference voltage; and
analyzing state information of the cell modules and transmitting control signals to the cell modules so that the respective cell modules may be individually charged to full capacity of the battery cell.

11. The method of claim 10, wherein
the determining is performed based on voltage information of the battery cells provided by the cell modules.

12. The method of claim 10, wherein
the stopping comprises:
reducing a current supply by controlling the external charger; and
stopping the current supplied to the battery cells by the external charger by controlling a switch between the external charger and the cell modules.
